# EUROPEAN PATENT APPLICATION

(11) **EP 1 763 117 A1**
(43) Date of publication of application: **14.03.2007**
(21) Application number: 06007620.5
(22) Date of filing: 11.04.2006
(51) Int. Cl.: H01S 5/227

(54) **Method for making reproducible buried heterostructure semiconductor devices**

(30) Priority: 12.09.2005 US 224409
(71) Applicant: Agilent Technologies, Inc., Santa Clara, CA 95051 (US)
(72) Inventor: Zhu, Jintian, Loveland, CO 80537-0599 (US); Hofler, Gloria Emilia, Loveland, CO 80537-0599 (US)
(74) Representative: Stöckeler, Ferdinand

(57) **Abstract**

A semiconductor device **100** and a method of manufacturing the semiconductor device **100.** The semiconductor device **100** includes a substrate **102,** an etching stop layer **106** disposed over the substrate **102,** and an active region layer **110** disposed on the etching stop layer **106.** The active region layer **110** is further disposed opposite the substrate **102.**

## Description

### DESCRIPTION OF RELATED ART

The performance and yield of semiconductor devices depends on processing methods that enable the confinement of current, carriers, and photons. The performance and yield of these devices also depends on guiding radiation along specific directions within the device. Fabrication using buried heterostructure geometry combines all of these features effectively, and is thus commonly used when manufacturing high power lasers, electro-absorption modulators, and waveguides. For these devices, a mesa is defined in the structure of the device by etching once the basic active region structure is in place. The width of the mesa influences the mode, shape, and laser threshold of the laser, and is involved in determining whether the laser has a single mode operation.

The process of creating a mesa involves the use of either wet chemical etching techniques or dry chemical etching techniques, such as reactive ion etching (RIE) or inductance coupled plasma (ICP) etching. Some wet etching solutions result in the width of the mesa stripes at the center region becoming wider than the edge region and, likewise, the height at the center area may become different than the height at the edge area, typically shallower. On the other hand, if the stripe width is controlled for single mode operation at the edge of the wafer, the stripe width will be too wide at the center of the mesa, creating undesirable higher order modes during operation of the device. In contrast, dry etching can result in very uniform stripe width. However, a drawback to dry etching is that the surface of the wafer can be very rough after the etching process. Hence, whatever etching method is chosen, optimal device performance and device yield cannot be achieved.

### SUMMARY OF THE INVENTION

The present invention relates to a semiconductor device and a method of manufacturing the semiconductor device. The semiconductor device includes a substrate, an etching stop layer grown over the substrate, and an active region layer grown on the etching stop layer. The active region layer is further grown or deposited opposite the substrate, and is thus disposed opposite the substrate. The Fe doped InP layer is deposited on both sides of the mesa for current and index confinement.

### BRIEF DESCRIPTION OF THE DRAWINGS

Furthermore, the invention provides embodiments and other features and advantages in addition to or in lieu of those discussed above. Many of these features and advantages are apparent from the description below with reference to the following drawings.
**FIG. 1** shows a semiconductor device with an etching stop layer according to an exemplary embodiment in accordance with the invention;
**FIG. 2** shows the semiconductor device of **FIG. 1** after a dielectric stripe is placed on the semiconductor device according to an exemplary embodiment in accordance with the invention;
**FIG. 3** shows the semiconductor device of **FIG. 2** after etching according to an exemplary embodiment in accordance with the invention;
**FIG. 4** shows the semiconductor device of **FIG. 3** after a second etching step according to an exemplary embodiment in accordance with the invention;
**FIG. 5** shows the semiconductor device of **FIG. 4** after adjusting the width of the mesa according to an exemplary embodiment in accordance with the invention;
**FIG. 6** shows the semiconductor device of **FIG. 5** after depositing a current blocking layer according to an exemplary embodiment in accordance with the invention; and
**FIG. 7** shows the semiconductor device of **FIG. 6** after depositing a top p-cladding layer and a contact layer according to an exemplary embodiment in accordance with the invention.

### DETAILED DESCRIPTION OF THE EXEMPLARY EMBODIMENTS OF THE INVENTION

Embodiments in accordance with the invention provide for a semiconductor device with an etching stop layer. The stop layer allows buried heterostructure semiconductor devices to be built reliably and consistently with a high yield.

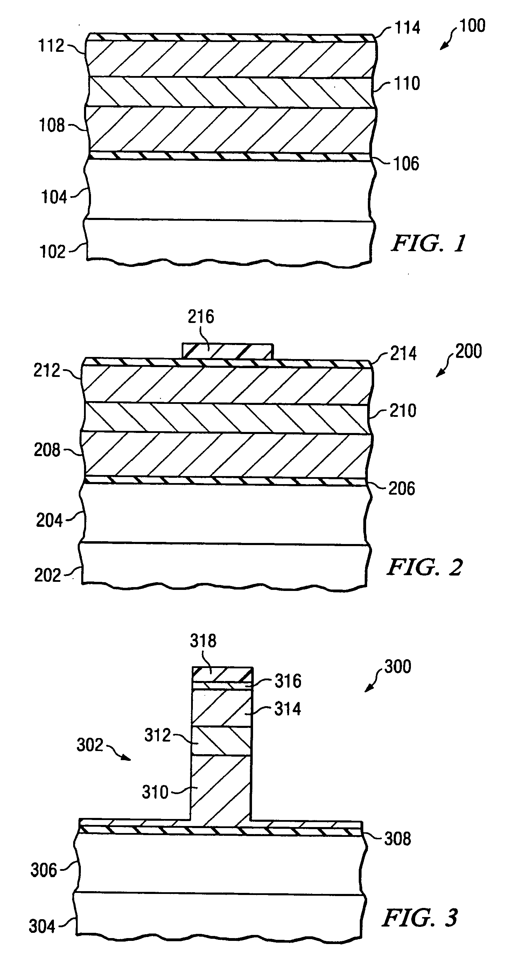

**FIG. 1** shows a semiconductor device with an etching stop layer according to an exemplary embodiment in accordance with the invention. **FIG. 1** shows the basic layer structure of semiconductor device **100** before the formation of a mesa. The construction of semiconductor device **100** may be considered the first step in building an exemplary embodiment of a completed semiconductor device, such as a laser, waveguide, or electro-absorption modulator. In this exemplary embodiment, semiconductor device **100** is built on substrate **102.** Substrate **102** in this exemplary embodiment is InP.

Optionally, buffer layer **104** is deposited and disposed on the substrate. In this exemplary embodiment, buffer layer **104** is made from n type InP. Buffer layer **104** minimizes the defect density in substrate **102.** Buffer layer **104** is typically about 1.5 µm thick.

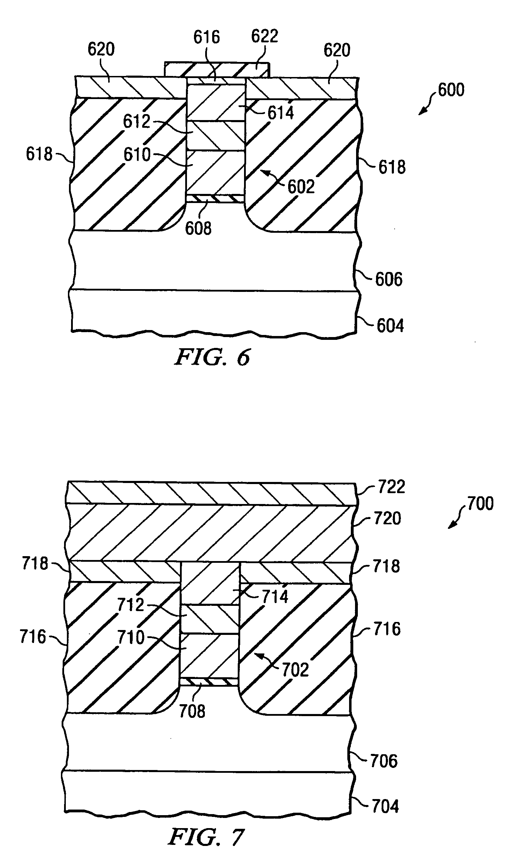

Etching stop layer **106** is deposited and disposed on buffer layer **104,** or may be deposited directly on substrate **102.** Etching stop layer **106** is made of materials resistant to etching processes. Etch-resistant materials suitable for use in etching stop layer **106** include InGaAsP and InGaAs. Etching stop layer **106** in the exemplary embodiment is disposed between active region layer **110** and buffer layer **104** or substrate **102.** Etching stop layer **106** in the exemplary embodiment is also very thin, such as about 10 nm. The thickness of etching stop layer **106** may vary between about 5 nm and 20 nm, in order to minimize problems with light propagation in the waveguide. The separation between etching stop layer **106** and active region layer **110** is determined by dielectric stripe width **216,** as shown in **FIG. 2,** and on the thickness of current blocking layer **618,** as shown in **FIG. 6.** For high-speed devices, etching stop layer **106** is about 1.5 µm below active region layer **110** and the photolithographic mask width, the area occupied by layers **618** and **620** shown in **Figure 6,** is about 3 µm in order to yield a mesa width of approximately 1.5 µm. The spacing between etching stop layer **106** and active region layer **110** may vary between about 1 µm and about 2 µm and the mask width may vary between about 3.5 µm and about 2.5 µm.

Deposited and disposed above etching stop layer **106** is n-cladding layer **108.** N-cladding layer **108** in the exemplary embodiment is made from n type InP.

Deposited and disposed above n-cladding layer **108** is active region layer **110.** Active region layer **110** may be formed from a plurality of sub-layers, each comprising different materials. In the exemplary embodiment, active region layer **110** forms a laser or waveguide, though active region layer could form any of a number of semiconductor devices. Materials suitable for use in active region layer **110** include InP, InGaAs, InGaAsP, InAlAs, AlInGaAs, and multi-layers made up from these materials.

Deposited and disposed above active region layer **110** is p-cladding layer **112.** P-cladding layer **112** is made from a p-type material. A p-type material is the type of conduction material used to form a PN junction. In the exemplary embodiment, p-cladding layer **112** is made from Zn doped InP.

Deposited and disposed above p-cladding layer **112** is surface freshening layer **114.** This layer has the dual purpose of defining the mesa etch profile and providing a fresh surface for regrowth of additional layers. In the exemplary embodiment, surface freshening layer **114** is made from InGaAsP, though surface freshening layer **114** may also be made from materials such as InGaAs. Surface freshening layer **114** will be removed just before p-cladding layer **720,** shown in **FIG. 7,** is grown. Surface freshening layer **114** is removed to avoid the surface from becoming contaminated.

In semiconductor device **100,** the various layers are disposed relative to substrate **102.** Thus, for example, etching stop layer **106** is disposed over substrate **102.** Similarly, active region layer **110** is disposed over etching stop layer **106** and is disposed over substrate **102.** For this reason, active region layer **110** may be characterized as disposed over etching stop layer **106** and opposite substrate **102.** The other layers, such as layers **104, 106, 108, 110, 112,** and **114,** may be similarly characterized in terms of location relative to substrate **102.** Thus, for example, once p-cladding layer **112** is added, p-cladding layer **112** may be characterized as over active region layer **110** and disposed opposite substrate **102** and etching stop layer **106.**

Each of the layers shown in **FIG. 1,** including layers **102, 104, 106, 108, 110, 112,** and **114,** may be built-up on substrate **102** using a variety of techniques. For example, metalorganic vapor phase epitaxy (MOVPE) or vapor phase epitaxy (VPE) may be used to build up the layers. Other techniques may be used according to the suitability or desirability of the deposition technique.

**FIG. 2** shows the semiconductor device of **FIG. 1** after dielectric stripe **216** is placed on semiconductor device **100** according to an exemplary embodiment in accordance with the invention. Thus, **FIG. 2** shows a second step in preparing semiconductor device **200** to form an exemplary embodiment of a completed device. Semiconductor device **200** is formed using semiconductor device **100** shown in **FIG. 1.** Accordingly, referring to **FIG. 1** and **FIG. 2,** semiconductor device **100** corresponds to semiconductor device **200,** substrate **202** corresponds to substrate **102,** buffer layer **204** corresponds to buffer layer **104,** etching stop layer **206** corresponds to etching stop layer **106,** n-cladding layer **208** corresponds to n-cladding layer **108,** active region layer **210** corresponds to active region layer **110,** p-cladding layer **212** corresponds to p-cladding layer **112,** and surface freshening layer **214** corresponds to surface freshening layer **114.**

Dielectric stripe **216** is added to top of surface freshening layer **214.** Dielectric stripe **216** is used to define the mesa width. Dielectric stripe **216** in the exemplary embodiment is made from SiNx or SiO2. The thickness of dielectric stripe **216** is about 500 nm, but may vary between about 450 nm and about 550 nm.

**FIG. 3** shows the semiconductor device of **FIG. 2** after etching according to an exemplary embodiment in accordance with the invention. Thus, **FIG. 3** shows a third step in preparing semiconductor device **300** to form an exemplary embodiment of a completed device. Semiconductor device **300** is formed using semiconductor device **200** shown in **FIG. 2.** Accordingly, referring to **FIG. 2** and **FIG. 3,** substrate **304** corresponds to substrate **202,** buffer layer **306** corresponds to buffer layer **204,** etching stop layer **308** corresponds to etching stop layer **206,** n-cladding layer **310** corresponds to n-cladding layer **208,** active region layer **312** corresponds to active region layer **210,** p-cladding layer **314** corresponds to p-cladding layer **212,** surface freshening layer **316** corresponds to surface freshening layer **214,** and dielectric stripe **318** corresponds to dielectric stripe **216.**

In the exemplary embodiment shown, **FIG. 3,** reactive ion etching, inductance coupled plasma etching, or other dry etching technique is used to etch away the unmasked or unpattemed portions of layers **316, 314, 312,** and the bulk of layer **310** to just above etching stop layer **308.** As a result, mesa **302** is formed. Mesa **302** allows the laser or waveguide to operate in single mode operation. The use of dry etching techniques generates a very uniform width for mesa **302.**

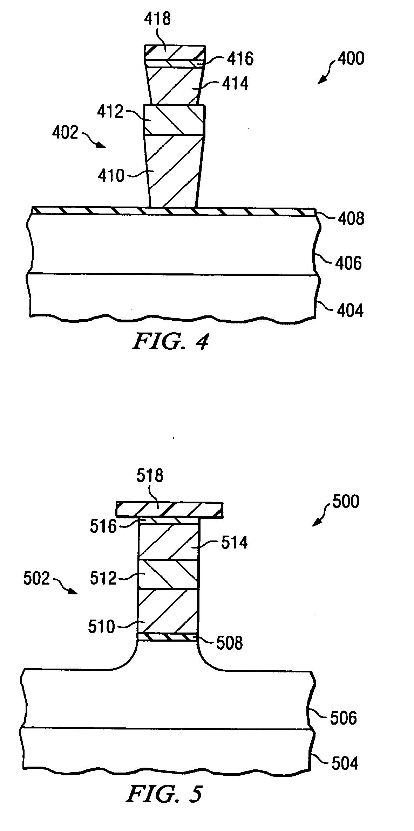

**FIG. 4** shows the semiconductor device of **FIG. 3** after a second etching step according to an exemplary embodiment in accordance with the invention. Thus, **FIG. 3** shows a fourth step in preparing semiconductor device **400** to form an exemplary embodiment of a completed device. Semiconductor device **400** is formed using semiconductor device **300** shown in **FIG. 3.** Accordingly, referring to **FIG. 3** and **FIG. 4,** mesa **402** corresponds to mesa **302,** substrate **404** corresponds to substrate **304,** buffer layer **406** corresponds to buffer layer **306,** etching stop layer **408** corresponds to etching stop layer **308,** n-cladding layer **410** corresponds to n-cladding layer **310,** active region layer **412** corresponds to active region layer **312,** p-cladding layer **414** corresponds to p-cladding layer **314,** surface freshening layer **416** corresponds to surface freshening layer **316,** and dielectric stripe **418** corresponds to dielectric stripe **318.**

After formation of mesa **402** using dry etching techniques, semiconductor device **400** is subjected to a selective wet etching solution. A selective wet etching solution only dissolves or attacks certain, targeted materials so that only certain layers are worn. In the exemplary embodiment, a solution of HCL and deionized water (H20) is used with a ratio of HCL:H20 = 2:1 or 1:1 in order to smooth the surface on etching stop layer **408.** However, other suitable solutions may be used, so long as any remaining portion of n-cladding layer **410** is removed above etching stop layer **408.** This wet etching process creates a very smooth surface across the surface of etching stop layer **408.** In addition, a portion of n-cladding layer **410** near etching stop layer **408** is also worn, slightly narrowing the base of n-cladding layer **410.** Similarly, a portion of p-cladding layer **414** is worn near active region layer **412,** slightly narrowing the base of p-cladding layer **414.**

**FIG. 5** shows the semiconductor device of **FIG. 4** after adjusting the width of the mesa according to an exemplary embodiment in accordance with the invention. Thus, **FIG. 5** shows a fifth step in preparing semiconductor device **500** to form an exemplary embodiment of a completed device. Semiconductor device **500** is formed using semiconductor device **400** shown in **FIG. 4.** Accordingly, referring to **FIG. 4** and **FIG. 5,** mesa **502** corresponds to mesa **402,** substrate **504** corresponds to substrate **404,** buffer layer **506** corresponds to buffer layer **406,** etching stop layer **508** corresponds to etching stop layer **408,** n-cladding layer **510** corresponds to n-cladding layer **410,** active region layer **512** corresponds to active region layer **412,** p-cladding layer **514** corresponds to p-cladding layer **414,** surface freshening layer **516** corresponds to surface freshening layer **416,** and dielectric stripe **518** corresponds to dielectric stripe **418.**

After wet etching with a selective solution, semiconductor device **500** is etched using a non-selective etching solution. A non-selective etching solution dissolves or attacks all of the materials of semiconductor device **500.** In the exemplary embodiment, a solution of HBr, hydrogen peroxide (H202), and deionized water (H20) is used as the non-selective etching solution,. A ratio of HBr:H202:H20 = 20:4:200 in order to wear a portion of all of the layers, especially from the sides of mesa **502.** However, other suitable solutions may be used, so long as damage from dry etching is removed and mesa **502** sidewalls are made smooth.

As a result of the process to this point, the width of mesa **502** is carefully and reproducibly controlled in order to ultimately control the performance of the finished device. In addition, the width of mesa **502** shrinks such that dielectric stripe **518** extends over the edges of mesa **502.** Because dielectric stripe **518** extends past the edges of mesa **502,** dielectric stripe **518** will prevent over-shoot of a later-added current blocking layer, such as current blocking layer **618** shown in **FIG. 6.**

**FIG. 6** shows the semiconductor device of **FIG. 5** after depositing a current blocking layer according to an exemplary embodiment in accordance with the invention. Thus, **FIG. 6** shows a sixth step in preparing semiconductor device **600** to form an exemplary embodiment of a completed device. Semiconductor device **600** is formed using semiconductor device **500** shown in **FIG. 5.** Accordingly, referring to **FIG. 5** and **FIG. 6,** mesa **602** corresponds to mesa **502,** substrate **604** corresponds to substrate **504,** buffer layer **606** corresponds to buffer layer **506,** etching stop layer **608** corresponds to etching stop layer **508,** n-cladding layer **610** corresponds to n-cladding layer **510,** active region layer **612** corresponds to active region layer **512,** p-cladding layer **614** corresponds to p-cladding layer **514,** surface freshening layer **616** corresponds to surface freshening layer **516,** and dielectric stripe **622** corresponds to dielectric stripe **518.**

After etching with a non-selective solution, current blocking layer **618** is deposited or added above buffer layer **606,** and around mesa **602.** In the exemplary embodiment, current blocking layer **618** is made of Fe doped InP and has a thickness of about 3 µm. Current blocking layer **618** may vary in thickness between about 2.5 µm and about 3.5 µm. Current blocking layer **618** provides current confinement at the active region.

After adding current blocking layer **618,** diffusion stopping layer **620** is deposited or added above current blocking layer **618** and around mesa **602.** In the exemplary embodiment, diffusion stopping layer **620** is made of Si doped InP having a thickness of about 0.4 µm. Thus, diffusion stopping layer **620** is adapted to block diffusion of Zn.

**FIG. 7** shows the semiconductor device of **FIG. 6** after depositing top p-cladding layer **720** and contact layer **722** according to an exemplary embodiment in accordance with the invention. Thus, **FIG. 7** shows a seventh step in preparing semiconductor device **700** to form an exemplary embodiment of a completed device. Semiconductor device **700** is formed using semiconductor device **600** shown in **FIG. 6.** Accordingly, referring to **FIG. 6** and **FIG. 7,** mesa **702** corresponds to mesa **602,** substrate **704** corresponds to substrate **604,** buffer layer **706** corresponds to buffer layer **606,** etching stop layer **708** corresponds to etching stop layer **608,** n-cladding layer **710** corresponds to n-cladding layer **610,** active region layer **712** corresponds to active region layer **612,** p-cladding layer **714** corresponds to p-cladding layer **614,** current blocking layer **716** corresponds to current blocking layer **618,** and diffusion stopping layer **718** corresponds to diffusion stopping layer **620.**

After adding current blocking layer **716** and diffusion stopping layer **718,** the dielectric stripe layer **622** in **FIG. 6** is removed. In the exemplary embodiment, dielectric stripe **622** is removed with HF. Surface freshening layer **616** is removed with a solution made from H2SO4:H2O:H2O2 in a ratio of 10:1:1. Thereafter, top p-cladding layer **720** is deposited or added over diffusion stopping layer **718** and over mesa **702.** Top p-cladding layer **720** is made from Zn doped InP. Top p-cladding layer **720** is about 1.5 µm thick, though may vary in thickness from about 1 µm to about 2 µm. After top p-cladding layer **720** has been added, contact layer **722** is added or deposited over top p-cladding layer **720.** Contact layer **722** may be made of Zn doped InGaAs or a variety of other materials, such as InGaAsP. Contact layer **722** is about 0.2 µm, but may vary in thickness from about 0.15 µm to about 0.25 µm.

While what has been described constitute exemplary embodiments in accordance with the invention, it should be recognized that the invention can be varied in numerous ways without departing from the scope thereof. Because embodiments in accordance with the invention can be varied in numerous ways, it should be understood that the invention should be limited only insofar as is required by the scope of the following claims.

## Claims

1. A semiconductor device comprising a substrate and an active region disposed over the substrate, the improvement comprising:
an etching stop layer disposed between the substrate and the active region.

2. The semiconductor device of claim 1 further comprising a p-cladding layer disposed over the active region layer, wherein the p-cladding layer is further disposed opposite the substrate and the etching stop layer.

3. The semiconductor device of claim 2 further comprising an n-cladding layer disposed over the etching stop layer, wherein the n-cladding layer is further disposed opposite the substrate.

4. The semiconductor device of claim 3 further comprising a freshening layer disposed over the p-cladding layer, wherein the feshening layer is further disposed opposite the substrate, the etching stop layer, and the n-cladding layer.

5. The semiconductor device of claim 1 wherein a distance between the etching stop layer and the active region is between about 1 µm and about 2 µm.

6. The semiconductor device of claim 1 further comprising a current blocking layer disposed over the etching stop layer and around a mesa extending from the etching stop layer.

7. The semiconductor device of claim 1 wherein a thickness of the etching stop layer is between about 5 nm and about 20 nm.

8. The semiconductor device of claim 2 further comprising a contact layer disposed over the p-cladding layer, wherein the contact layer is further disposed opposite the substrate and the active region layer.

9. The semiconductor device of claim 1 further comprising a buffer layer disposed between the substrate and the etching stop layer.

10. The semiconductor device of claim 1 wherein the semiconductor device is formed by etching the active region.
